# EUROPEAN PATENT APPLICATION

(11) **EP 2 424 053 A1**
(43) Date of publication of application: **29.02.2012**
(21) Application number: 09843631.4
(22) Date of filing: 20.04.2009
(51) Int. Cl.: H02B 1/28

(54) **UNIT FOR HOUSING ELECTRONIC APPARATUS**

(71) Applicant: Mitsubishi Electric Corporation, Tokyo 100-8310 (JP)
(72) Inventor: YATOU, Tadashi, Nakatsugawa-shi Gifu 508-0041 (JP); KUMAGAI, Hideomi, Tokyo 102-0073 (JP); TOMITA, Chikako, Tokyo 102-0073 (JP); KATO, Yasuhiro, Tokyo 102-0073 (JP); NAKABAYASHI, Hirokazu, Tokyo 100-8310 (JP); TASHIRO, Takeshi, Tokyo 106-6135 (JP)
(74) Representative: Pfenning, Meinig & Partner GbR
(86) International application number: PCT/JP2009/057873
(87) International publication number: WO 2010/122631

(57) **Abstract**

The waterproof walls 31a and 31b are provided on the upper portion of the front door 15, the waterproof wall 31a is arranged across both-side end portions of the front door 15 along the upper end portion of the front door 15 and the waterproof wall 31b is arranged in parallel with the waterproof wall 31a in a state of being spaced apart from the waterproof wall 31a, and the side plate 13a for the top plate is configured to cover the waterproof walls 31a and 31b to be spaced apart from the waterproof walls 31a and 31b.

## Description

### Field

The present invention relates to an electronic device accommodating unit, particularly to a waterproof structure of a power conditioner for outdoor installation used in a photovoltaic system.

### Background

A power conditioner is used for enabling to convert a direct current power generated by solar cells into an alternating current power and to supply it to a load or supply excess power to an electric power company. When this power conditioner is installed outside, it is generally performed to take a waterproof measure by using packing or caulking for ensuring an internal waterproof property even if the power conditioner is exposed to rainwater at the time of occurrence of a typhoon or the like (Patent Literature 1).

### Citation List

### Patent Literature

Patent Literature 1: Japanese Utility Model Application Publication No. H6-84707

### Summary

### Technical Problem

However, in the method of taking the waterproof measure by using packing or caulking, when the power conditioner is installed outside, the packing and the caulking are exposed to strong sunshine or wind and rain. Therefore, there is a problem that the packing and the caulking degrade early, and if the power conditioner is used for a long period of time, a sufficient waterproof property cannot be obtained, so that the service life of the power conditioner becomes short.

The present invention is achieved in view of the above, and has an object to obtain an electronic device accommodating unit capable of ensuring a waterproof property while improving a weather resistance.

### Solution to Problem

In order to solve the aforementioned problems, an electronic device accommodating unit according to one aspect of the present invention is configured to include: a casing in which a bottom plate, a back plate, a top plate, a front door, and a pair of side plates are provided; a first waterproof wall arranged along an upper end portion of the front door; a second waterproof wall arranged in parallel with the first waterproof wall; and a side plate for the top plate that is provided on the top plate and is arranged to cover the first waterproof wall and the second waterproof wall and to be spaced apart from the first waterproof wall and the second waterproof wall.

### Advantageous Effects of Invention

According to this invention, the effects are obtained that a waterproof property can be ensured while improving a weather resistance.

### BRIEF DESCRIPTION OF DRAWINGS

[FIG. 1] FIG. 1 is a perspective view illustrating a schematic configuration of a photovoltaic system to which a first embodiment of an electronic device accommodating unit according to the present invention is applied.
[FIG. 2] FIG. 2 is a perspective view illustrating a schematic configuration of an inside of a front-stage portion FB of a power conditioner 3 partitioned by a partition plate 18.
[FIG. 3] FIG. 3 is a perspective view illustrating a schematic configuration of an inside of a back-stage portion BB of the power conditioner 3 partitioned by the partition plate 18.
[FIG. 4] FIG. 4 is a perspective view illustrating a state of the electronic device accommodating unit in FIG. 1 before attaching a top plate 13.
[FIG. 5] FIG. 5 is a perspective view illustrating a state in which the electronic device accommodating unit according to the present invention after attaching the top plate 13 of the first embodiment is cut along a line A-A' in FIG. 4.
[FIG. 6] FIG. 6 is a perspective view illustrating a state in which the electronic device accommodating unit according to the present invention after attaching the top plate 13 of a second embodiment is cut along the line A-A' in FIG. 4.
[FIG. 7] FIG. 7 is a perspective view illustrating a state in which the electronic device accommodating unit according to the present invention after attaching a top plate 53 of a third embodiment is cut along the line A-A' in FIG. 4.
[FIG. 8] FIG. 8 is a perspective view illustrating a state in which the electronic device accommodating unit according to the present invention after attaching a top plate 63 of a fourth embodiment is cut along the line A-A' in FIG. 4.

### Description of Embodiments

An exemplary embodiment of an electronic device accommodating unit according to the present invention will be explained below in detail based on the drawings. This invention is not limited to this embodiment.

### First Embodiment

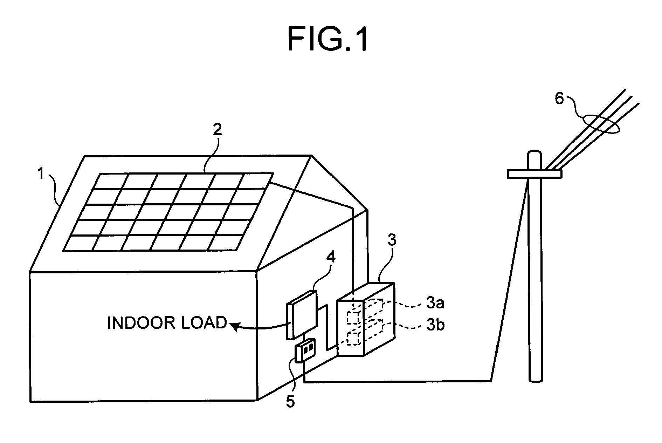

FIG. 1 is a perspective view illustrating a schematic configuration of a photovoltaic system to which the embodiment of the electronic device accommodating unit according to the present invention is applied. In the following embodiment, a power conditioner is explained as the electronic device accommodating unit as an example, however, the electronic device accommodating unit is not limited to the power conditioner and, for example, can be applied to an air conditioning apparatus such as an air conditioner, or the like.

In FIG. 1, a solar panel 2 that converts light into a direct current power is installed on a roof 1 and a power conditioner 3 is installed outside. The solar panel 2 is connected to the DC input terminal of the power conditioner 3. Moreover, the AC output terminal of the power conditioner 3 is connected to an indoor load via a distribution board 4 and is connected to a distribution line 6 via the distribution board 4 and an electricity meter 5.

In the power conditioner 3, a DCDC converter 3a that performs DC conversion of a direct current power generated in the solar panel 2 and an inverter 3b that converts the direct current power output from the DCDC converter 3a into an alternating current power are incorporated.

Then, when the direct current power generated in the solar panel 2 is sent to the power conditioner 3, DC conversion of the direct current power is performed in the DCDC converter 3a, and thereafter, the direct current power is converted into the alternating current power in the inverter 3b to be sent to the distribution board 4. Then, when the alternating current power is sent to the distribution board 4, the alternating current power is supplied to the indoor load and excess power is sent to the distribution line 6 to be taken by an electric power company.

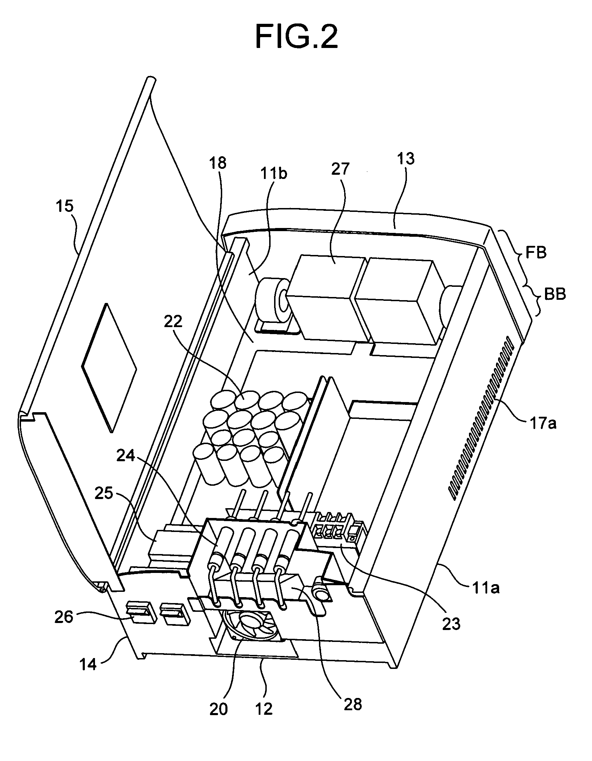

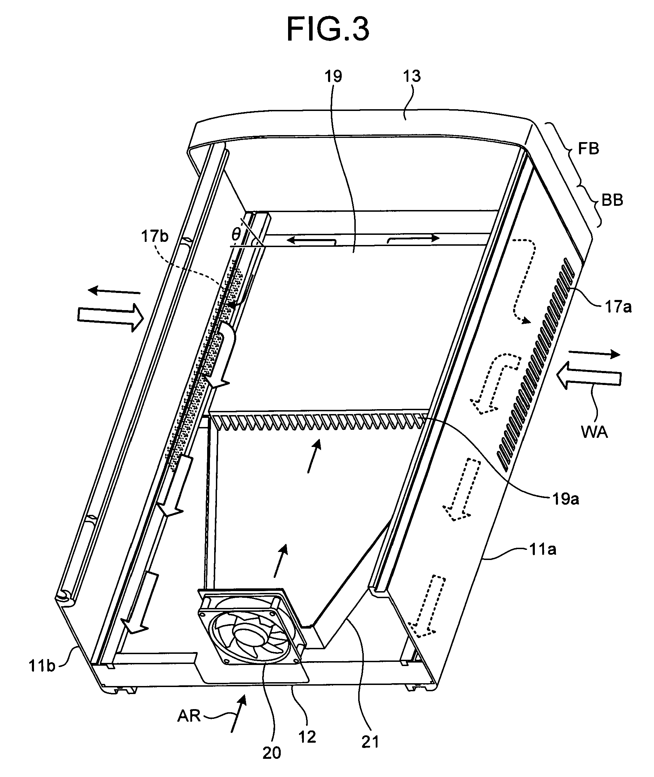

FIG. 2 is a perspective view illustrating a schematic configuration of an inside of a front-stage portion FB of the power conditioner 3 partitioned by a partition plate 18, and FIG. 3 is a perspective view illustrating a schematic configuration of an inside of a back-stage portion BB of the power conditioner 3 partitioned by the partition plate 18. In FIG. 2 and FIG. 3, in the power conditioner 3 in FIG. 1, a bottom plate 14, a back plate 12, a top plate 13, a front door 15, and a pair of side plates 11a and 11b are provided as a casing. The top plate 13 is provided with a side plate 13a for the top plate along the outer edge portion thereof. Moreover, the front door 15 is attached to the side plates 11a and 11b in a vertically slidable manner. The bottom plate 14, the back plate 12, the top plate 13, the front door 15, and a pair of the side plates 11a and 11b can be formed of, for example, metal such as iron, stainless steel, or aluminum. The casing of the power conditioner 3 is partitioned by the partition plate 18 in the depth direction to be divided into the front-stage portion FB and the back-stage portion BB.

In the lower portion of the power conditioner 3, a blower 20 that blows air into the casing through the bottom plate 14 is arranged. The blowing direction of the blower 20 can be set upward by arranging the blower 20 in such a manner as to face the bottom plate 14.

Moreover, as shown in FIG. 3, in the back-stage portion BB of the power conditioner 3, in the upper portion of the power conditioner 3, a heat sink 19 in which heat dissipation fins 19a are formed is arranged. In the heat sink 19, the heat dissipation fins 19a are arranged along the blowing direction of the blower 20 in such a manner as to face the back plate 12. Moreover, the heat sink 19 is arranged such that there are clearances between the side surfaces of the heat sink 19 and the side plates 11a and 11b and there is a clearance between the upper end portion of the heat sink 19 and the top plate 13.

Furthermore, in the back-stage portion BB of the power conditioner 3, exhaust openings 17a and 17b are formed in the side plates 11a and 11b, respectively. The exhaust openings 17a and 17b can be formed into, for example, a slit shape. The exhaust openings 17a and 17b can be arranged to communicate with the clearances between the side surfaces of the heat sink 19 and the side plates 11a and 11b. Moreover, the exhaust openings 17a and 17b can be formed to communicate with the inside of the back-stage portion BB of the power conditioner 3 and not to communicate with the inside of the front-stage portion FB of the power conditioner 3. Furthermore, the exhaust openings 17a and 17b are preferably arranged at the position lower than the lines that intersect with the side plates 11a and 11b when being drawn in the direction of the side plates 11a and 11b from the upper end portion of the side surfaces of the heat sink 19 at an angle θ of 45°.

Moreover, a separator 21 is arranged between the blower 20 and the side plates 11a and 11b. This separator 21 can separate an air passage from the blower 20 to the heat sink 19 from air passages along the side plates 11a and 11b that communicate with the exhaust openings 17a and 17b.

On the other hand, as shown in FIG. 2, in the front-stage portion FB of the power conditioner 3, capacitors 22, a surge absorber 25, a reactor 27, and the like are arranged on the partition plate 18. The partition plate 18 can be arranged on the heat dissipation surface of the heat sink 19 to cover the clearances between the side surfaces of the heat sink 19 and the side plates 11a and 11b and the clearance between the upper end portion of the heat sink 19 and the top plate 13. The capacitors 22, the surge absorber 25, the reactor 27, and the like can be used as electronic components forming the DCDC converter 3a and the inverter 3b in FIG. 1.

Moreover, on the partition plate 18, an AC terminal block 23, DC input terminals 24, and the like are arranged, and a switch 26 is attached to the bottom plate 14. Furthermore, the portion of the blower 20 projecting to the front-stage portion FB side is covered by a blower cover 28. The blower cover 28 can send air AR taken in by the blower 20 to the back-stage portion BB side.

Then, the air AR taken in by the blower 20 is sent to the back-stage portion BB side by the blower cover 28, and is sent to the lower end portion of the heat sink 19 through the air passage defined by the back plate 12, the partition plate 18, and the separator 21.

Then, the air AR sent to the lower end portion of the heat sink 19 is discharged from the upper end portion of the heat sink 19 while cooling the heat sink 19 by passing between the heat dissipation fins 19a. Then, the path of the air AR discharged from the upper end portion of the heat sink 19 is bent by the top plate 13 to be directed to the directions of the side plates 11a and 11b. Then, the air AR directed to the directions of the side plates 11a and 11b travels through the clearances between the side surfaces of the heat sink 19 and the side plates 11a and 11b and is discharged to the outside through the exhaust openings 17a and 17b.

On the other hand, when the power conditioner 3 is installed outside, the power conditioner 3 is exposed to strong sunshine or wind and rain. Then, when the power conditioner 3 is exposed to wind and rain, if rainwater WA enters the inside via the exhaust openings 17a and 17b, the rainwater WA falls downward of the power conditioner 3 by gravity. When the rainwater WA falls downward of the power conditioner 3 by gravity, ingress of the rainwater WA to the blast surface of the blower 20 is prevented by the side surfaces of the heat sink 19 and the separator 21 and the ingress of the rainwater WA to the inside of the front-stage portion FB is prevented by the partition plate 18.

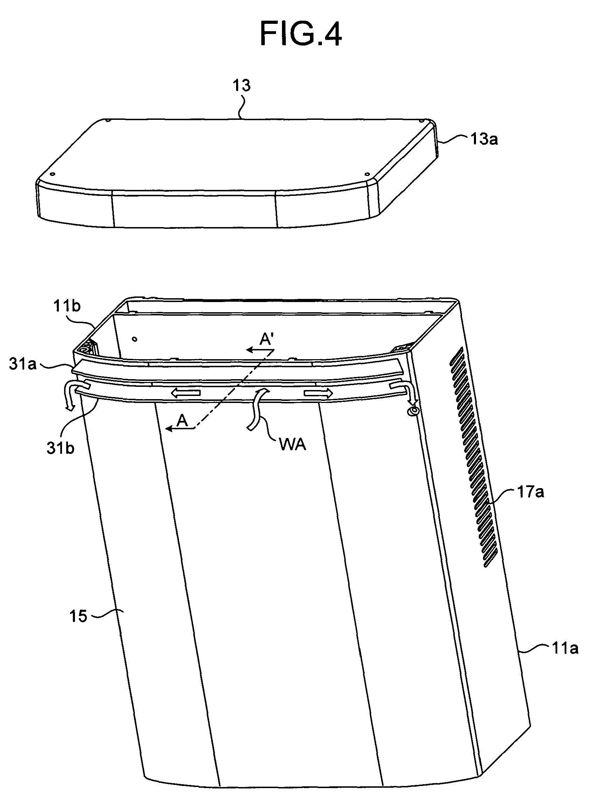

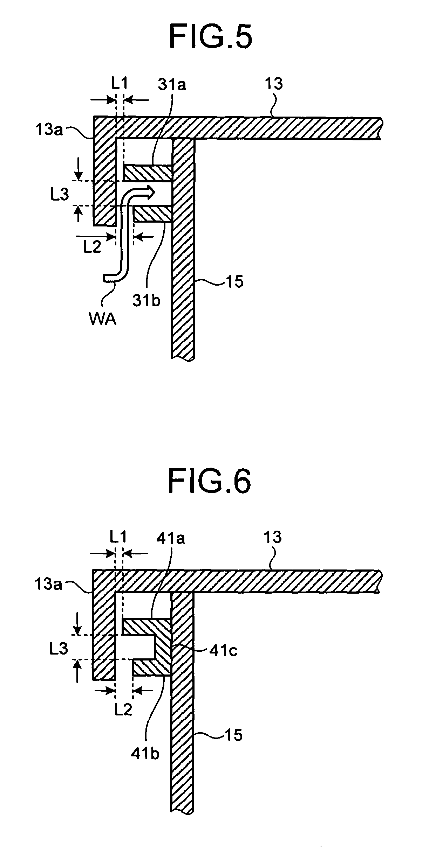

FIG. 4 is a perspective view illustrating a state of the electronic device accommodating unit shown in FIG. 1 before attaching the top plate 13, and FIG. 5 is a perspective view illustrating a state in which the electronic device accommodating unit according to the present invention after attaching the top plate 13 of the first embodiment is cut along the line A-A' in FIG. 4.

In FIG. 4 and FIG. 5, waterproof walls 31a and 31b are provided on the upper portion of the front door 15. The waterproof wall 31a is arranged across both-side end portions of the front door 15 along the upper end portion of the front door 15 and the waterproof wall 31b is arranged in parallel with the waterproof wall 31a in a state of being spaced apart from the waterproof wall 31a.

The side plate 13a for the top plate is configured to cover the waterproof walls 31a and 31b to be spaced apart from the waterproof walls 31a and 31b when the top plate 13 is attached to the power conditioner 3 in FIG. 1. The side plate 13a for the top plate and the waterproof walls 31a and 31b can be formed of, for example, metal such as iron, stainless steel, or aluminum. Moreover, the side plate 13a for the top plate can be configured integrally with the top plate 13. Furthermore, the waterproof walls 31a and 31b can be fixed to the front door 15, for example, by a method such as screwing.

An interval L1 between the side plate 13a for the top plate and the waterproof wall 31a is preferably smaller than an interval L2 between the side plate 13a for the top plate and the waterproof wall 31b. Moreover, the interval between the waterproof walls 31a and 31b is preferably 2 mm or more.

When a typhoon or the like occurs, the front door 15 is exposed to wind and rain. Then, when the rainwater WA enters the boundary between the front door 15 and the side plate 13a for the top plate, the force of the rainwater WA is reduced by the waterproof wall 31a and thereafter the rainwater WA enters the clearance between the waterproof walls 31a and 31b. Then, the rainwater WA entered the clearance between the waterproof walls 31a and 31b travels in a lateral direction along the clearance between the waterproof walls 31a and 31b and is discharged from the end portions of the waterproof walls 31a and 31b.

Consequently, even when the rainwater WA enters the boundary between the front door 15 and the side plate 13a for the top plate, it is possible to prevent the rainwater WA from entering inside of the power conditioner 3 from the clearance between the front door 15 and the top plate 13 and therefore prevent the electric components of the power conditioner 3 from getting wet by the rainwater WA. Therefore, the waterproof property of the electric components of the power conditioner 3 can be ensured without taking a waterproof measure using packing or caulking. Thus, even when the power conditioner 3 is installed outside, the service life of the power conditioner 3 can be prolonged.

Moreover, because it is not needed to take a waterproof measure by using packing or caulking, workability for taking a waterproof measure can be improved and disassembly of the power conditioner 3 can be facilitated.

Furthermore, the rainwater WA can be prevented from passing through the waterproof walls 31a and 31b due to a capillary action by providing a clearance between the side plate 13a for the top plate and the waterproof walls 31a and 31b, enabling to improve the waterproof effect.

In the above described embodiment, the method of providing the waterproof walls 31a and 31b on the upper portion of the front door 15 is explained, however, the waterproof walls 31a and 31b can be provided also on the upper portion of the side plates 11a and 11b.

### Second Embodiment

FIG. 6 is a perspective view illustrating a state in which the electronic device accommodating unit according to the present invention after attaching the top plate 13 of the second embodiment is cut along the line A-A' in FIG. 4. In FIG. 6, waterproof walls 41a and 41b are provided on the upper portion of the front door 15. The waterproof walls 41a and 41b are connected with each other by a connecting plate 41c. The waterproof walls 41a and 41b and the connecting plate 41c can be integrally configured to have a C-shape. The waterproof wall 41a is arranged across both-side end portions of the front door 15 along the upper end portion of the front door 15 and the waterproof wall 41b is arranged in parallel with the waterproof wall 41a in a state of being spaced apart from the waterproof wall 41a.

The side plate 13a for the top plate is configured to cover the waterproof walls 41a and 41b to be spaced apart from the waterproof walls 41a and 41b when the top plate 13 is attached to the power conditioner 3 in FIG. 1. The waterproof walls 41a and 41b and the connecting plate 41c can be formed of, for example, metal such as iron, stainless steel, or aluminum. Moreover, the waterproof walls 41a and 41b and the connecting plate 41c can be fixed to the front door 15, for example, by a method such as screwing.

The interval L1 between the side plate 13a for the top plate and the waterproof wall 41a is preferably smaller than the interval L2 between the side plate 13a for the top plate and the waterproof wall 41b. Moreover, the interval between the waterproof walls 41a and 41b is preferably 2 mm or more.

The waterproof walls 41a and 41b can be used integrally by connecting the waterproof walls 41a and 41b with each other by the connecting plate 41c, so that workability when fixing the waterproof walls 41a and 41b to the front door 15 can be improved.

### Third Embodiment

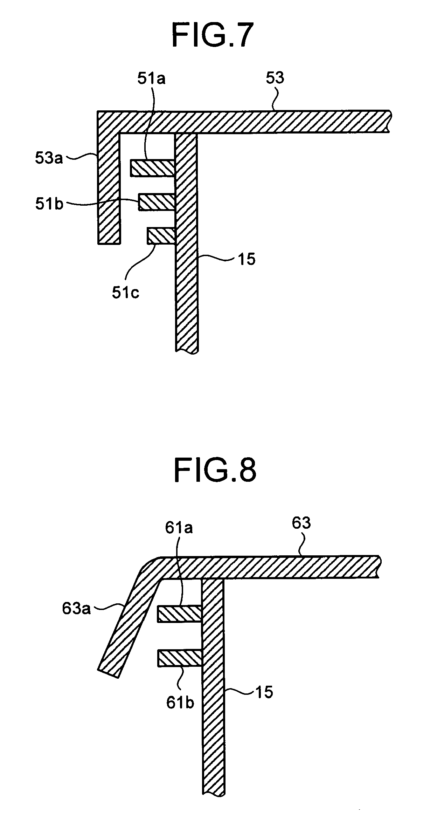

FIG. 7 is a perspective view illustrating a state in which the electronic device accommodating unit according to the present invention after attaching a top plate 53 of the third embodiment is cut along the line A-A' in FIG. 4. In FIG. 7, waterproof walls 51a to 51c are provided on the upper portion of the front door 15. The waterproof wall 51a is arranged across both-side end portions of the front door 15 along the upper end portion of the front door 15, the waterproof wall 51b is arranged in parallel with the waterproof wall 51a in a state of being spaced apart from the waterproof wall 51a, and the waterproof wall 51c is arranged in parallel with the waterproof walls 51a and 51b in a state of being spaced apart from the waterproof walls 51a and 51b.

A side plate 53a for the top plate is configured to cover the waterproof walls 51a to 51c to be spaced apart from the waterproof walls 51a to 51c when the top plate 53 is attached to the power conditioner 3 in FIG. 1. The waterproof walls 51a to 51c can be formed of, for example, metal such as iron, stainless steel, or aluminum. Moreover, the waterproof walls 51a to 51c can be fixed to the front door 15, for example, by a method such as screwing.

The interval between the side plate 53a for the top plate and the waterproof walls 51a to 51c preferably becomes smaller as they are arranged closer to the top plate 53.

Ingress of the rainwater WA can be prevented in three stages by providing the waterproof walls 51a to 51c, enabling to improve the waterproof property.

In the above described third embodiment, the method of providing the three parallel waterproof walls 51a to 51c on the front door 15 is explained, however, four or more parallel waterproof walls can be provided on the front door 15. Moreover, as shown in FIG. 6, it is applicable to connect the waterproof walls 51a to 51c with each other via a connecting plate to enable to use the waterproof walls 51a to 51c integrally.

### Fourth Embodiment

FIG. 8 is a perspective view illustrating a state in which the electronic device accommodating unit according to the present invention after attaching a top plate 63 of the fourth embodiment is cut along the line A-A' in FIG. 4. In FIG. 8, waterproof walls 61a and 61b are provided on the upper portion of the front door 15. The waterproof wall 61a is arranged across both-side end portions of the front door 15 along the upper end portion of the front door 15 and the waterproof wall 61b is arranged in parallel with the waterproof wall 61a in a state of being spaced apart from the waterproof wall 61a.

A side plate 63a for the top plate is configured to cover the waterproof walls 61a and 61b to be spaced apart from the waterproof walls 61a and 61b when the top plate 63 is attached to the power conditioner 3 in FIG. 1. Moreover, the side plate 63a for the top plate is configured to be directed obliquely downward with respect to the top plate 63. The waterproof walls 61a and 61b can be formed of, for example, metal such as iron, stainless steel, or aluminum. Moreover, the waterproof walls 61a and 61b can be fixed to the front door 15, for example, by a method such as screwing.

The side plate 63a for the top plate is configured to be directed obliquely downward with respect to the top plate 63, so that the interval between the side plate 63a for the top plate and the waterproof wall 61a can be made smaller than the interval between the side plate 63a for the top plate and the waterproof wall 61b without changing the dimension of the waterproof walls 61a and 61b, enabling to improve the production efficiency of the waterproof walls 61a and 61b.

### Industrial Applicability

As above, the electronic device accommodating unit according to the present invention can prevent rainwater or the like from entering an electric component in a casing without using packing or caulking even in the case of being installed outside, and therefore is suitable for a waterproof structure of a power conditioner for outdoor installation.

### Reference Signs List

1 ROOF
2 SOLAR PANEL
3 POWER CONDITIONER
3a DCDC CONVERTER
3b INVERTER
4 DISTRIBUTION BOARD
5 ELECTRICITY METER
6 DISTRIBUTION LINE
11a, 11b SIDE PLATE
12 BACK PLATE
13 TOP PLATE
14 BOTTOM PLATE
15 FRONT DOOR
17a, 17b EXHAUST OPENING
18 PARTITION PLATE
19 HEAT SINK
19a HEAT DISSIPATION FIN
20 BLOWER
21 SEPARATOR
22 CAPACITOR
23 AC TERMINAL BLOCK
24 DC INPUT TERMINAL
25 SURGE ABSORBER
26 SWITCH
27 REACTOR
28 BLOWER COVER
31a, 31b, 41a, 41b, 51a to 51c, 61a, 61b WATERPROOF WALL
41c CONNECTING PLATE

## Claims

1. An electronic device accommodating unit comprising:
a casing in which a bottom plate, a back plate, a top plate, a front door, and a pair of side plates are provided;
a first waterproof wall arranged along an upper end portion of the front door;
a second waterproof wall arranged in parallel with the first waterproof wall; and
a side plate for the top plate that is provided on the top plate and is arranged in such a manner as to cover the first waterproof wall and the second waterproof wall and to be spaced apart from the first waterproof wall and the second waterproof wall.

2. The electronic device accommodating unit according to claim 1, further comprising a connecting plate that is formed integrally with the first waterproof wall and the second waterproof wall to connect the first waterproof wall and the second waterproof wall.

3. The electronic device accommodating unit according to claim 1 or 2, wherein a clearance between the first waterproof wall and the second waterproof wall is 2 mm or more.

4. The electronic device accommodating unit according to claim 1 or 2, wherein
the first waterproof wall is arranged closer to the top plate than the second waterproof wall, and
an interval between the first waterproof wall and the side plate for the top plate is smaller than an interval between the second waterproof wall and the side plate for the top plate.
